# EUROPÄISCHE PATENTANMELDUNG

(11) **EP 0 936 677 A1**
(43) Veröffentlichungstag der Anmeldung: **18.08.1999**
(21) Anmeldenummer: 98810119.2
(22) Anmeldetag: 16.02.1998
(51) Int. Cl.: H01L 29/78, H01L 29/739, H01L 21/225, H01L 21/331, H01L 21/336, H01L 29/417, H01L 29/06

(54) **Leistungshalbleiterbauelement mit einer isolierten Gateelektrode und Verfahren zu dessen Herstellung**

(71) Anmelder: Asea Brown Boveri AG, 5401 Baden (CH)
(72) Erfinder: Bauer, Friedhelm, Dr., 5702 Niederlenz (CH)
(74) Vertreter: Weibel, Beat

(57) **Zusammenfassung**

Es wird ein Leistungshalbleiterbauelement angegeben, bei dem die Dreischichtstruktur mit der Gateoxidschicht, der leitenden Gateelektrode und der die Gateelektrode bedeckenden Isolationsschicht bis auf die Oberfläche des Halbleitersubstrats reichende Gräben aufweist, die mit einer leitenden Polysiliziumschicht angefüllt sind. Die Polysiliziumschicht ist derart strukturiert, dass sie oberhalb der n+ Sourcegebiete n dotiert und in den übrigen Bereichen p dotiert ist.

## Beschreibung

### Technisches Gebiet

Die Erfindung bezieht sich auf das Gebiet der Leistungshalbleitertechnologie. Sie geht aus von einem Verfahren zur Herstellung eine Leistungshalbleiterbauelements mit isolierter Gateelektrode bzw. einen solchen Leistungshalbleiterbauelement gemäss dem Oberbegriff der unabhängigen Ansprüche.

### Stand der Technik

Für die Weiterentwicklung von IGBTs insbesondere in Richtung von Hochspannungsanwendungen werden insbesondere Strukturen mit einer Anreicherung des Plasmas an der Kathode bevorzugt. Solche IGBTs weisen eine thyristorähnliche Plasmaverteilung auf und sind demzufolge auch bezüglich der Durchlassverluste mit z.B. GTOs vergleichbar. Sogenannte Trench-IGBTs wurden mit diesem Ziel entwickelt. Trench-IGBTs sind jedoch nur sehr schwierig und teuer herzustellen, so dass eine kommerzielle Anwendung dieser Technologie im Moment zumindest in Frage gestellt ist. Darüber hinaus ist bis heute noch nicht klar, wie mit den Trench-IGBTs eine mit planaren Strukturen vergleichbare Kurzschlussfestigkeit erreicht werden kann.

### Darstellung der Erfindung

Aufgabe der Erfindung ist es, ein Leistungshalbleiterbauelement mit isolierter Gateelektrode bzw. ein Herstellungsverfahren desselben anzugeben, das die erwünschte kathodenseitige Plasmaanreicherung aufweist und zudem eine hohe Kurzschlussfestigkeit aufweist. Diese Aufgabe wird durch die Merkmale der unabhängigen Ansprüche gelöst.

Kern der Erfindung ist es also, dass die Dreischichtstruktur mit der Gateoxidschicht, der leitenden Gateelektrode und der die Gateelektrode bedeckenden Isolationsschicht bis auf die Oberfläche des Halbleitersubstrats reichende Gräben aufweist, die mit einer leitenden Polysiliziumschicht angefüllt sind. Ausserdem ist die Polysiliziumschicht derart strukturiert, dass sie oberhalb der n+ Sourcegebiete n dotiert und in den übrigen Bereichen p dotiert ist.

Das erfindungsgemässe Verfahren zeichnet sich im wesentlichen dadurch aus, dass zunächst die erwähnte Dreischichtstruktur und darin Gräben gebildet werden. Anschliessend werden die Wände und der Boden der Gräben oxidiert und der Boden wird von der so gebildeten SiO₂-Schicht wieder frei gemacht. Im nächsten Schritt werden die Gräben mit der Polysiliziumschicht angefüllt und es werden die p-Basis bzw. die n+ dotierte Sourcegebiete gebildet.

In einem ersten Ausführungsbeispiel sind die n dotierten Bereiche der die Gräben anfüllenden Polysiliziumschicht in ihrer lateralen Ausdehnung auf die Grabenbreite beschränkt. Ein zweites Ausführungsbeispiel ist dadurch charakterisiert, dass die n dotierten Bereiche oberhalb der n+ Sourcegebiete seitlich versetzt sind und die SiO₂-Isolationsschicht teilweise überdecken.

Die Erfindung wird mit Vorteil für IGBTs, die anodenseitig einen p+ dotierte Emittergebiet aufweisen, aber auch für MOSFETs, bei denen der p+ Anodenemitter fehlt, eingesetzt. Die Vorteile der Erfindung sind insbesondere darin zu sehen, dass durch die erfindungsgemässe Strukturierung der Gräben entlang der isolierten Wände im Durchlass Verarmungszonen entstehen, die den Strompfad der Löcher einschnüren. Dadurch wird eine Erhöhung des Widerstands und folglich eine Plasmaanreicherung im Siliziumsubstrat erreicht. Die Erhöhung der Plasmadichte hat ihrerseits eine Verminderung der Durchlassverluste zur Folge. Beim Abschalten mit einer negativen Gatespannung entstehen in den Gräben Akkumulationszonen, die an den Grenzflächen eine sehr hohe Löcherleitfähigkeit besitzen. Damit wird in diesem kritischen Stadium der Bahnwiderstand durch den MOS-Feldeffekt erniedrigt, d.h. die Latch-up Festigkeit und auch die Kurzschlussfestigkeit erhöht.

Die Erfindung ist anwendbar für IGBTs und MOSFETs. Weitere vorteilhafte Ausführungsformen ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1 - 9**: Verschiedene Schritte bei der Herstellung eines erfindungsgemässen Bauelements;
- **Fig. 10**: Ein erstes Ausführungsbeispiel der Erfindung;
- **Fig. 11**: Ein zweites Ausführungsbeispiel der Erfindung.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. In den Figuren sind n-dotierte Gebiete mit von rechts oben nach links unten verlaufenden Linien schraffiert, p-dotierte Gebiete mit von links oben nach rechts unten verlaufenden Linien. Das Gateoxid und die SiO2-Isolationsschicht ist mit kurzen waagrechten Strichen schraffiert. Die Gateelektrode ist mit abwechselnd dicken und dünnen, von rechts oben nach links unten verlaufenden Linien schraffiert. Metallisierungen sind mit abwechselnd dicken und dünnen, von links oben nach rechts unten verlaufenden Linien schraffiert.

### Wege zur Ausführung der Erfindung

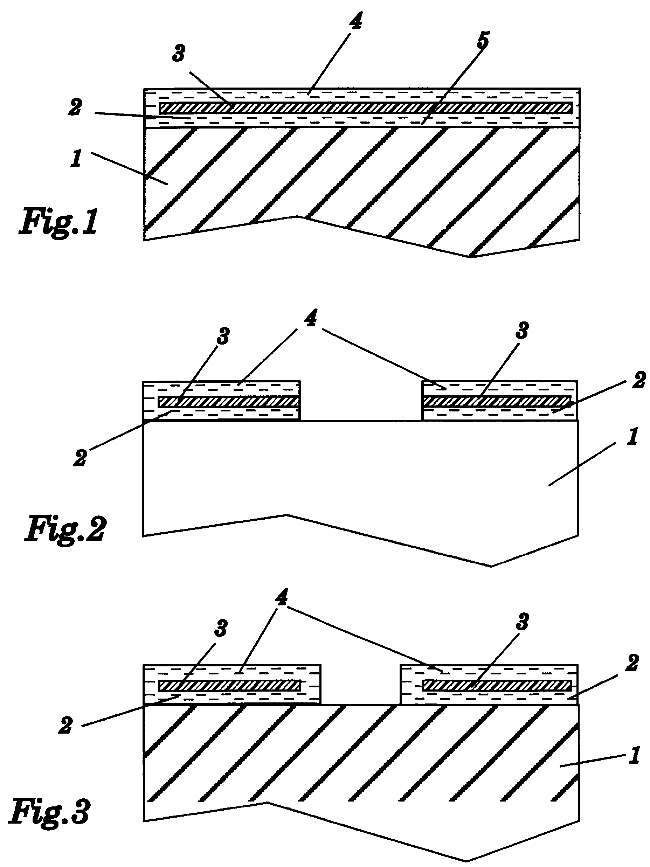

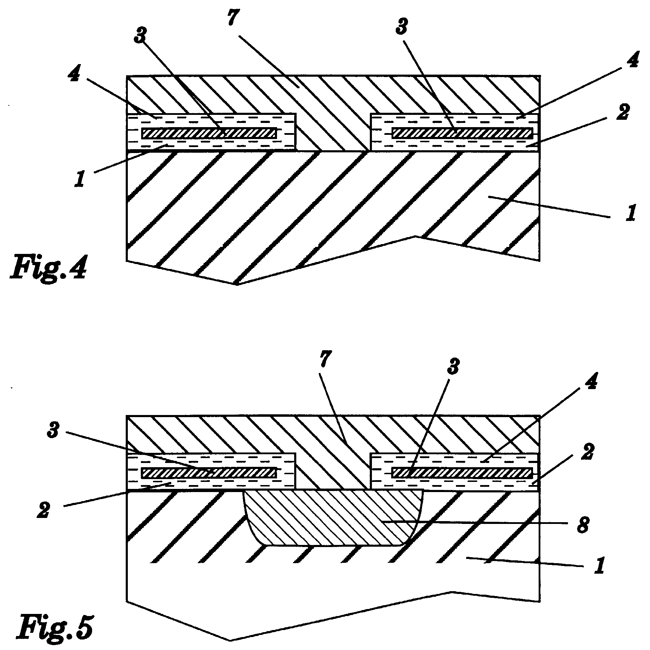

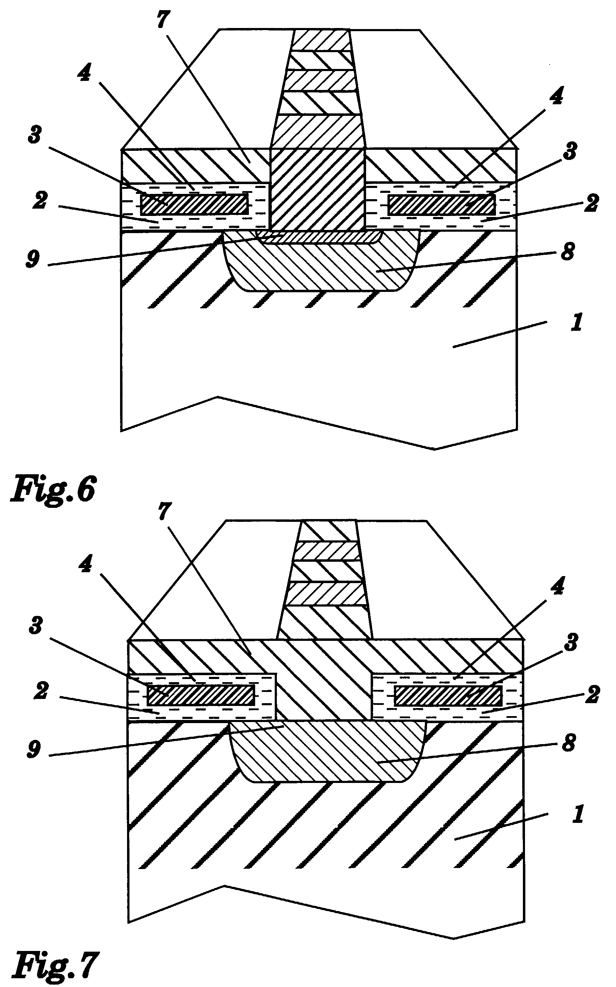

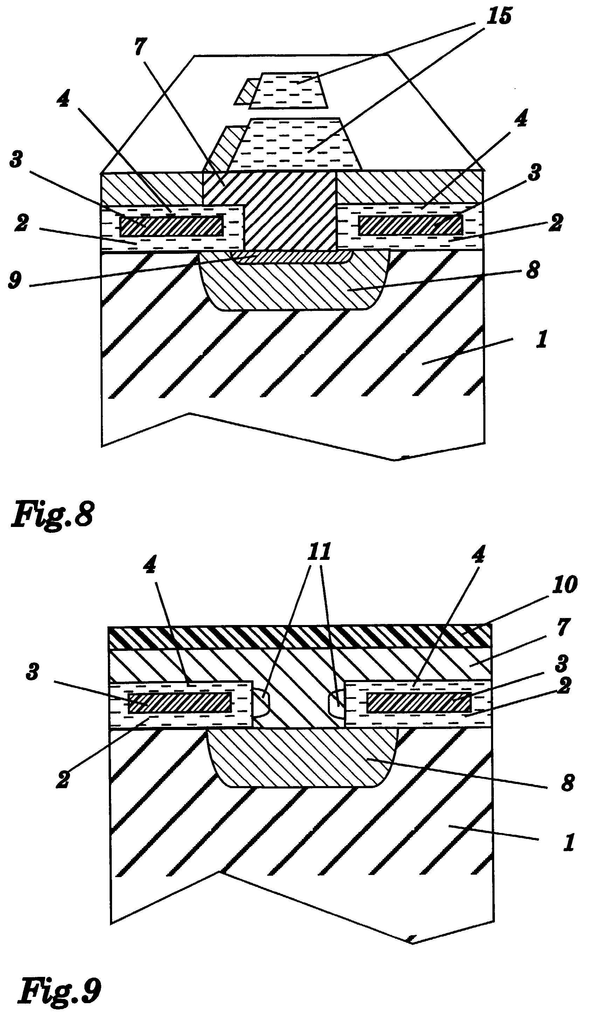

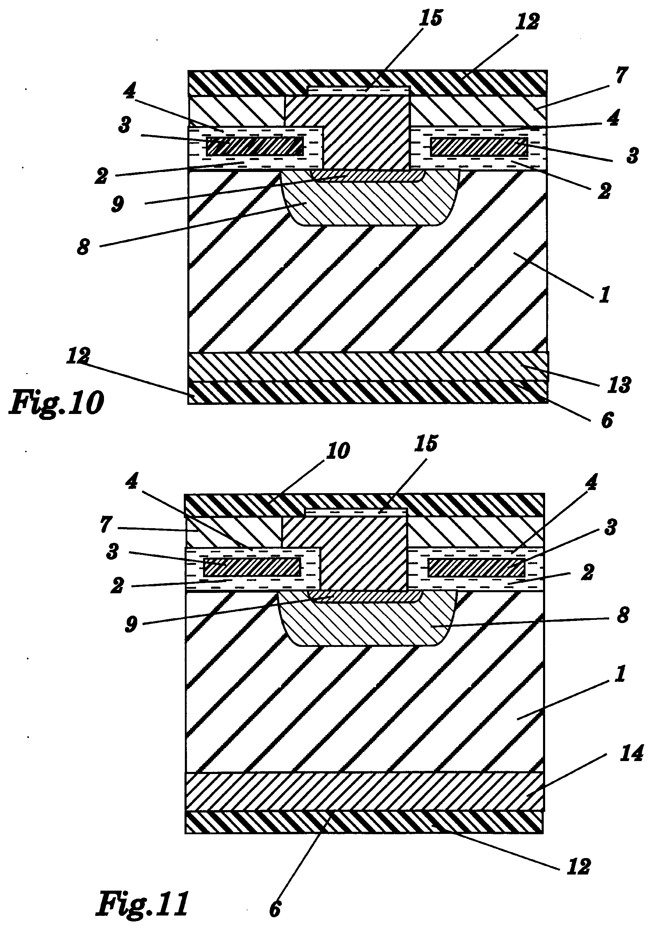

Die Figuren 1 bis 9 zeigen verschiedene Schritte bei der Herstellung eines erfindungsgemässen Bauelements. Die Halbleiterschichten des Bauteils sind nur insoweit dargestellt, wie es für das Verständnis der Erfindung notwendig ist. Dasselbe gilt für die Metallisierungen. Es wird im folgenden nur eine Einheitszelle betrachtet. In einem funktionstüchtigen Bauelement sind jedoch eine Mehrzahl von parallelgeschalteten Einheitszellen vorgesehen. Das Herstellungsverfahren geht aus von einem Halbleitersubstrat 1 mit einer ersten, in den Figuren oberen Hauptfläche 5 und einer zweiten, hier nicht dargestellten Hauptfläche 6. In einem ersten Schritt wird eine Dreischichtstruktur mit einem Gateoxid 2, einer ersten Polysiliziumschicht 3 und einer darüber angebrachten SiO₂-Isolationsschicht auf die erste Hauptfläche 5 aufgebracht (Figur 1). In diese Dreischichtstruktur werden nachfolgend Gräben mit möglichst steilen Flanken anisotrop bis auf die erste Hauptfläche 5 geätzt. Die Breite der Gräben liegt im Bereich von 0.5 µm bis 1.5 µm (Figur 2) Anschliessend werden die Grabenwände thermisch oxidiert. Dadurch entsteht an den Wänden und am Boden der Gräben eine SiO₂-Isolationsschicht. Die Isolationsschicht an den Wänden dient der Isolierung der Gateelektrode 3, und die Dicke sollte demzufolge im Bereich von 50 nm bis 100 nm liegen. Die Grabenböden hingegen werden wieder freigeätzt (Figur 3). Nachfolgend wird eine weitere Polysiliziumschicht 7 deponiert und die Gräben damit vollständig gefüllt. Die Polysiliziumschicht 7 ist p-dotiert (Figur 4). Die Dotierung liegt etwa bei 10¹⁷ cm⁻³. Wegen der Korngrenzen im Polysilizium liegt die Leitfähigkeit dieser Polysiliziumschicht etwas unter einer gleich hoch dotierten einkristallinen Siliziumschicht. Diese Polysiliziumschicht wird in einem weiteren Schritt als Diffusionsquelle für den Drive-in der p-Basis 8 in das Halbleitersubstrat 1 (Figur 5). Die p-Basis weist somit eine wannenförmige bis unter die Gateelektrode 3 reichende Form auf. Im folgenden Maskenschritt werden entlang des p-Basis- Streifens in regelmässigen Abständen Gebiete definiert. In diesen Gebieten wird die Dotierung anschliessend mittels Überkompensation vom p-Typ in den n-Typ umgewandelt. Aus diesen Gebieten dringt eine sehr flache n+ Source 9 in die p-Basis 8 ein (Figur 6). In den übrigen Gebieten bleibt die Polysiliziumschicht 7 p-dotiert (Figur 7). In üblicher Weise wird die strukturierte Polysiliziumschicht 7 deckend metallisiert. Die Metallisierung ist mit 10 bezeichnet und in Figur 9, 10 und 11 dargestellt.

Das erfindungsgemässe Halbleiterbauelement, im Schnitt dargestellt in den Figuren 9, 10 und 11 funktioniert wie folgt: Aus den Studien zur Plasmaanreichetung bei Trench-IGBTs ist bekannt, dass eine Widerstand im Strompfad der Löcher diesen Effekt hervorruft. Ein Nachteil dieses erhöhten Widerstandes besteht jedoch darin, dass die latch-up Festigkeit stark verschlechtert wird. In Figur 9 ist dargestellt, dass bei der erfindungsgemässen Struktur im Durchlass, d.h. bei einer Gatespannung von z.B. +15V, in den Grabenbereichen entlang der oxidierten Grabenwände Verarmungszonen 11 entstehen. Diese Verarmungszonen 11 schnüren den Strompfad für die Löcher ein und bewirken somit eine Erhöhung des Widerstandes und damit eine Plasmaanreicherung im Substrat. Ausserdem trägt die vergleichsweise schwache Leitfähigkeit des schwach p-dotierten Polysiliziumgebiets 7 zu diesem Effekt bei. Die p-Dotierung dieses Gebiets muss so eingestellt werden, dass eine sinnvolle Modulation des Querschnitts des Löcherstrompfades eintritt.

Bei Abschalten des Elements mit negativer Gatespannung (z.B. -15V) verschwinden die einengenden Raumladungszonen 7. Es entstehen sogar Akkumulationszonen, die an den Grenzflächen sehr hohe Löcherleitfähigkeiten besitzen. Damit wird der Bahnwiderstand in diesem kritischen Stadium durch den MOS Feldeffekt erniedrigt, so dass die latch-up Festigkeit wunschgemäss erhöht werden kann. Neu gegenüber dem Stand der Technik ist ausserdem, dass die Plasmaanreicherung durch die Reduzierung des Widerstandes im Löcherpfad während des Abschaltens automatisch rückgängig gemacht wird. Damit werden auch niedrigere Schaltverluste und ein verbesserter Gesamt-trade-off erreicht.

Um die Bauelementeigenschaften optimal einstellen zu können, müssen die Weiten der n- und p-dotierten Grabengebiete richtig dimensioniert werden. Unterhalb der n+ Sourcegebiete 9 müssen die Löcher in Längsrichtung des durch den mit der zweiten Polysiliziumschicht 7 gefüllten Graben fliessen, um in den Bereich der p-dotierten Grabengebiete zu gelangen. Wegen der Forderung nach hoher Latch-up-Festigkeit sollte die Weite der n-dotierten Grabenbereiche 3 µm nicht überschreiten. Die Weite der p-dotierten Grabengebiete sollte hingegen so gering wie möglich sein, damit der Widerstand im Löcherstrompfad maximal wird. Eine untere Grenze setzt wiederum die geforderte Latch-up-Festigkeit. Sie liegt ungefähr bei 1 µm. Durch eine Ausdehnung der n-Dotierung der zweite Polysiliziumschicht über das isolierte Gate (Fig. 8, 10, 11) und eine teilweise Isolierung (15) kann ein zusätzlicher Emitter-Ballast-Widerstand eingebaut werden. Dieser Widerstand senkt die Sättigungsströme und erhöht die Latch-up-Festigkeit.

Die erfindungsgemässe Struktur kann sowohl bei einem IGBT, der auf der zweiten Hauptfläche 6 einen p+ dotierten, mit einer Metallisierung 12 überdeckten Anodenemitter 13 aufweist, als auch bei einem MOSFET mit einer n+ Drain 14 im Bereich der zweiten Hauptfläche 6 realisiert werden

### Bezugszeichenliste

- 1: Halbleitersubstrat
- 2: Gateoxid
- 3: erste Polysiliziumschicht, Gateelektrode
- 4: SiO2-Isolationsschicht
- 5: erste Hauptfläche
- 6: zweite Hauptfläche
- 7: zweite Polysiliziumschicht
- 8: p-Basis
- 9: Sourcegebiet
- 10: kathodenseitige Metallisierung
- 11: Verarmungszone
- 12: anodenseitige Metallisierung
- 13: Anodenemitter
- 14: Drain

## Patentansprüche

**1.** Leistungshalbleiterbauelement mit isolierter Gateelektrode, umfassend
(a) ein n dotiertes Halbleitersubstrat (1) mit einer ersten und einer zweiten Hauptfläche (5 und 6), eine Dreischichtstruktur mit von der ersten Hauptfläche (5) her gesehen einer Gateoxidschicht (2), einer leitenden, n+ dotierten, die Gateelektrode bildenden ersten Polysiliziumschicht (3) und einer die Gateelektrode bedeckenden ersten SiO₂-Isolationsschicht (4),
(b) wannenförmige, in das Halbleitersubstrat (1) eingelassene p-Basisgebiete (8) und in die p-Basisgebiete (8) eingelassene n+ Sourcegebiete (9),
(c) eine erste und zweite Metallisierung (10 und 12), wobei die zweite Metallisierung (12) die zweite Hauptfläche (6) bedeckt,
dadurch gekennzeichnet, dass
(d) die Dreischichtstruktur bis zur ersten Hauptfläche (5) reichenden Gräben aufweist, die mit einer zweiten Polysiliziumschicht (3) gefüllt sind,
(e) die zweite Polysiliziumschicht oberhalb der n+ Sourcegebiete (9) bereichsweise n dotiert und in den übrigen Bereichen p dotiert ist und die Dreischichtstruktur überdeckt,
(f) die erste Metallisierung (10) die zweite Polysiliziumschicht (3) überdeckt.

**2.** Leistungshalbleiterbauelement nach Anspruch 1, dadurch gekennzeichnet, dass die Bereiche oberhalb der n+ dotierten Sourcegebiete (9), in denen die zweite Polysiliziumschicht (7) n dotiert ist, in ihrer lateralen Ausdehnung auf die Grabenbreite beschränkt sind.

**3.** Leistungshalbleiterbauelement nach Anspruch 1, dadurch gekennzeichnet, dass
(a) die Bereiche oberhalb der n+ dotierten Sourcegebiete (9), in denen die zweite Polysiliziumschicht (7) n dotiert ist, seitlich versetzt sind, so dass sie die erste SiO2-Isolationsschicht (4) bereichsweise überdecken, und
(b) die Bereiche der zweiten Polysiliziumschicht (7) oberhalb der n+ dotierten Sourcegebiete (9) bereichsweise isoliert sind.

**4.** Leistungshalbleiterbauelement nach Anspruch 1, 2 oder 3, dadurch gekennzeichnet, dass von der zweiten Hauptfläche (6) her ein p+ dotiertes Emittergebiet (13) in das Halbleitersubstrat (1) eingelassen ist, das von der zweiten Metallisierung (12) kontaktiert wird.

**5.** Leistungshalbleiterbauelement nach Anspruch 1, 2 oder 3, dadurch gekennzeichnet, dass von der zweiten Hauptfläche (6) her ein n+ dotiertes Draingebiet (14) in das Halbleitersubstrat (1) eingelassen ist, das von der zweiten Metallisierung (12) kontaktiert wird.

**4.** Verfahren zur Herstellung eines Leistungshalbleiterbauelements mit isolierter Gateelektrode, bei welchem Verfahren in einem n dotierten Halbleitersubstrat (1) mit einer ersten und einer zweiten Hauptfläche (5 und 6) eine Mehrzahl von unterschiedlichen Gebieten gebildet wird, wobei
(a) in einem ersten Schritt auf der ersten Hauptfläche (5) des Halbleitersubstrats (1) eine Dreischichtstruktur mit von der ersten Hauptfläche her gesehen einer Gateoxidschicht (2), einer leitenden, n+ dotierten, die Gateelektrode bildenden ersten Polysiliziumschicht (3) und einer die Gateelektrode (3) bedeckenden ersten SiO₂-Isolationsschicht (4) gebildet wird;
dadurch gekennzeichnet, dass
(b) in einem zweiten Schritt in der Dreischichtstruktur bis auf die erste Hauptfläche (5) reichende Gräben gebildet werden;
(c) in einem dritten Schritt die Wände und der Boden der Gräben oxidiert und der Grabenboden von der so gebildeten isolierenden zweiten SiO2-Schicht wieder frei gemacht wird;
(d) in einem vierten Schritt eine zweite, p dotierte Polysiliziumschicht (7) auf der Dreischichtstruktur deponiert und die Gräben mit dieser Polysiliziumschicht (7) gefüllt werden;
(e) in einem fünften Schritt eine p-Basis (8) im Bereich der Gräben in das Halbleitersubstrat eindiffundiert wird, wobei die zweite Polysiliziumschicht (7) als Diffusionsquelle dient;
(f) in einem sechsten Schritt die Leitfähigkeit der zweiten Polysiliziumschicht (7) entlang der damit gefüllten Gräben durch Dotierung bereichsweise umgekehrt wird, wodurch in der p-Basis (8) und der zweiten Polysiliziumschicht (7) n+ dotierte Sourcegebiete (9) entstehen;
(g) in einem siebten Schritt die zweite Polysiliziumschicht (7) deckend metallisiert wird.
